# EUROPEAN PATENT SPECIFICATION

(11) **EP 3 185 302 B1**
(45) Date of publication and mention of the grant of the patent: **09.05.2018**
(21) Application number: 17154908.2
(22) Date of filing: 25.03.2015
(51) Int. Cl.: H01L 29/775, H01L 21/336, H01L 29/06, H01L 29/10, B82Y 10/00, B82Y 40/00, H01L 29/20, H01L 21/02, H01L 29/423

(54) **GATE-ALL-AROUND SEMICONDUCTOR DEVICE WITH TWO GROUP III-V SEMICONDUCTOR NANOWIRES**
GATE-RUNDHERUM HALBLEITERBAUELEMENT MIT ZWEI GRUPPE III-V HALBLEITER NANODRÄHTE
DISPOSITIF À SEMI-CONDUCTEUR À GRILLE TOUT-AUTOUR AVEC DEUX NANOFILS EN SEMICONDUCTEUR DE LA GROUPE III-V

(30) Priority: 27.03.2014 EP 14162027
(43) Date of publication of application: 28.06.2017
(62) Divisional of application: 15160743.9
(73) Proprietor: IMEC vzw, 3001 Leuven (BE)
(72) Inventor: Waldron, Niamh, 3001 Leuven (BE); Merckling, Clement, 3001 Leuven (BE); Collaert, Nadine, 3001 Leuven (BE)
(74) Representative: Patent Department IMEC

(56) References cited:
- WO-A1-2006/125826
- WO-A1-2010/090978
- WO-A1-2013/095651
- WO-A1-2014/018182
- US-A1- 2013 168 771
- US-A1- 2014 027 783
- MERCKLING C ET AL: "Heteroepitaxy of InP on Si(001) by selective-area metal organic vapor-phase epitaxy in sub-50 nm width trenches: The role of the nucleation layer and the recess enginee", JOURNAL OF APPLIED PHYSICS, AMERICAN INSTITUTE OF PHYSICS, US, vol. 115, no. 2, 14 January 2014 (2014-01-14), XP012180500, ISSN: 0021-8979, DOI: 10.1063/1.4862044 [retrieved on 1901-01-01]

## Description

### Field of the disclosure

The present disclosure relates to a method for manufacturing a semiconductor device, more specifically a method for manufacturing a gate all around (GAA) semiconductor device. The present disclosure also relates to a gate all around (GAA) semiconductor device, more specifically a gate all around (GAA) nanostructure semiconductor device.

### State of the art

High mobility materials such as III-V material are drawing much attention for CMOS at advanced technology nodes (10nm and beyond). In order to meet the required specifications of these advanced nodes in terms of short channel control (such as subtreshold slope and drain-induced barrier lowering) a tri-gate quantum well structure or a gate all around structure/nanowire (GAA/NW) structure is required to maintain electrostatic control.

III-V GAA devices reported to date have been fabricated by growing blanket layers on an entire III-V wafer (typically 2" or 4" substrates) as for example disclosed in "First experimental demonstration of gate-all-around III-V MOSFETs by top-down approach", by Gu et al. as published in IEEE IEDM 2011 pp. 769-772. The heterostructure layers are then patterned and the dummy buffer layer removed by means of a wet etch to release the nanowire.

However integrating these structures at the very large scale integration (VLSI) level on 300mm or larger wafers is a considerable technical challenge. To be competitive, III-V materials should be monolithically integrated with Si, in order to benefit from the existing Si-based semiconductor processing. The use of Si as a substrate would also enable the integration of several functional blocks on the same platform, such as for example logic, high-frequency, and I/O circuitry.

### Summary of the disclosure

The present invention relates to a gate-all-around (GAA) semiconductor device according to claim 1. It is an aim of the present disclosure to provide for a gate-all-around (GAA) semiconductor device, which is compatible with current and future technology nodes (1X technology nodes and below) wherein III-V channel materials are integrated with semiconductor based substrates (preferably Si-based substrates). According to the invention, a gate-all-around (GAA) semiconductor device is disclosed comprising a semiconductor substrate comprising a first crystalline semiconductor material; two suspended nanowires horizontally adjacent at a distance D being located at least partially above and in between a pair of adjacent STI regions and the two suspended nanowires being held in place by a source region and a drain region at both ends of the two suspended nanowires, the two suspended nanowires comprising a crystalline III-V semiconductor material which is different from the first crystalline semiconductor material, wherein a cavity is present between the suspended nanowires, opposite sidewalls of the STI regions and a top surface portion of the semiconductor substrate, the top surface portion extending between the pair of STI regions, wherein the suspended nanowires are wrapped by a final gate stack and wherein the top surface and the sidewalls of the STI regions and the exposed surface of the semiconductor substrate inside the cavity are also covered by the final gate stack, and wherein the distance D is larger than the thickness of the final gate stack and is smaller than the width of the cavity.

The first crystalline semiconductor material is preferably Si and the third crystalline semiconductor material comprises preferably a Group III-V material.

According to embodiments of the second aspect the suspended nanostructures have a width below 10 nm, preferably between 2nm and 10nm.

It is an advantage of embodiments of the present disclosure that III-V on Si GAA devices may be manufactured using a full wafer approach, i.e. using wafer of at least 300mm (also often referred to as '12 inch') wafer size.

It is an advantage of embodiments of the present disclosure that III-V materials may be integrated on Si without the use of expensive and small III-V wafers and/or without the use of expensive and thick strain relaxed buffer (SRB)-based substrates. It is thus an advantage of embodiments of the present disclosure that the method for forming III-V GAA semiconductor devices is less expensive than methods as known for a person skilled in the art.

It is an advantage of embodiments of the present disclosure that III-V semiconductor device may be provided with a better electrostatic control and Vt control by substrate bias.

It is an advantage of embodiments of the present invention that very narrow nanostructures may be formed (i.e. smaller than 10 nm) without the need for etching.

### Brief description of the drawings

The disclosure will be further elucidated by means of the following description and the appended figures.
Figure 1 to 6 schematically illustrates different steps from a method for manufacturing a gate all around semiconductor device comprising one nanostructure, not forming part of the claimed invention.
Figure 7 to 10 and figure 14 schematically illustrates different steps from a method for manufacturing a gate all around semiconductor device comprising two nanostructures.
Figure 11 to 13 and figure 16 schematically illustrates different steps from a method for manufacturing a gate all around semiconductor device comprising at least one nanostructure.
Figure 15 schematically illustrates a top view of a gate all around semiconductor device after performing some of the steps from a method for manufacturing a gate all around semiconductor device comprising at least one nanostructure.
Figure 17 schematically illustrates a gate all around semiconductor device comprising two nanostructures according to embodiments of the present disclosure, and Figure 29 such a device with only one nanostructure.
Figure 18 schematically illustrates a gate all around semiconductor device comprising one nanostructure.
Figure 19 and 20 show a secondary electron microscopy (SEM) image of a gate all around semiconductor device comprising one nanostructure.
Figure 21 to 25 show experimental results relating to the device characteristics of a gate all around semiconductor device comprising at least one nanostructure.
Figure 26 schematically illustrates different process steps from a method for manufacturing a gate all around semiconductor device comprising at least one nanostructure.
Figure 27 shows a secondary electron microscopy (SEM) image of a gate all around semiconductor device comprising at two nanostructures according to embodiments of the present disclosure.
Figure 28 show experimental results relating to the device characteristics of a gate all around semiconductor device comprising two nanostructures according to embodiments of the present disclosure.
Figure 30 show simulation results relating to the device characteristics of a gate all around semiconductor device.
The drawings are only schematic and are non-limiting. In the drawings, the size of some of the elements may be exaggerated and not drawn on scale for illustrative purposes. The dimensions and the relative dimensions do not necessarily correspond to actual reductions to practice of the invention.

Any reference signs in the claims shall not be construed as limiting the scope.

In the different drawings, the same reference signs refer to the same or analogous elements.

### Detailed description of the disclosure

The disclosure will be further elucidated by means of the following detailed description of several embodiments of the disclosure and the appended figures.

In the following detailed description, numerous specific details are set forth in order to provide a thorough understanding of the disclosure and how it may be practiced in particular embodiments. However, it will be understood that the present disclosure may be practiced without these specific details. In other instances, well-known methods, procedures and techniques have not been described in detail, so as not to obscure the present disclosure. While the present disclosure will be described with respect to particular embodiments and with reference to certain drawings, the disclosure is not limited hereto. The drawings included and described herein are schematic and are not limiting the scope of the disclosure. It is also noted that in the drawings, the size of some elements may be exaggerated and, therefore, not drawn to scale for illustrative purposes.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B.

III-V materials have attracted much interest as a potential high mobility channel material for advanced scaling nodes. However, due to low effective mass and density of states (DOS), InGaAs based channel devices are expected to suffer from worse short channel effects (SCE) compared to Si. This makes the gate-all-around architecture very interesting for III-V as it offers increased electrostatic control over planar or FinFet devices and InGaAs GAA transistors fabricated on small InP substrates show very promising results.

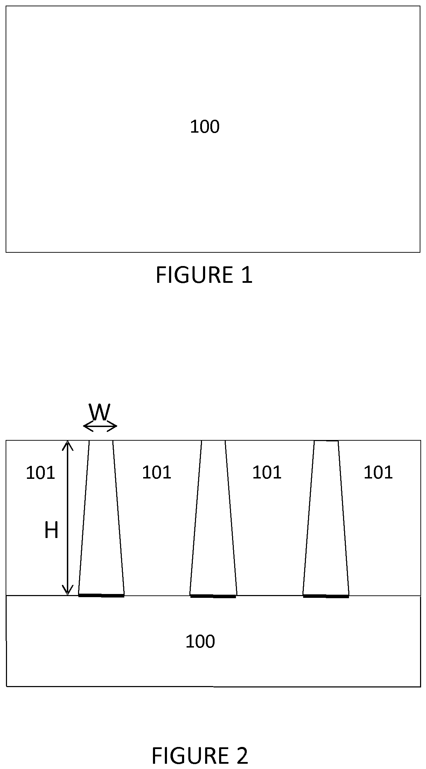

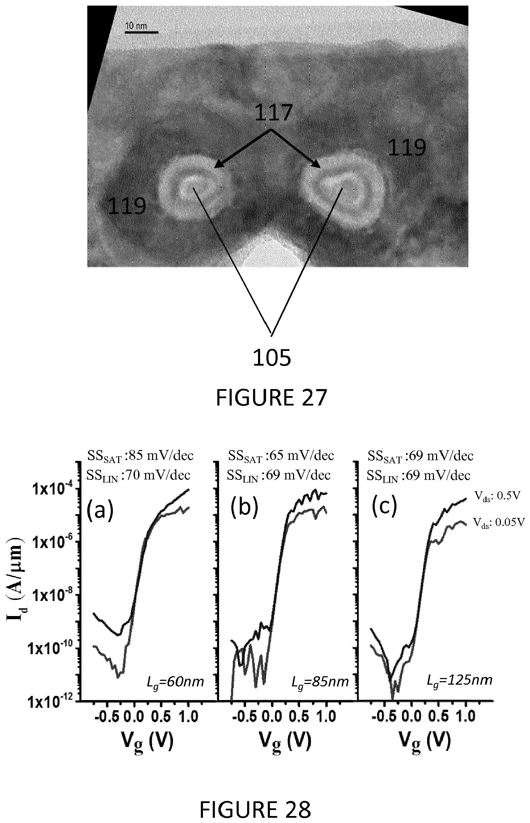

Whenever there is referred to a nanostructure this may be regarded as a structure with a cross-section which has a height or/and width less than 20nm, more preferably less than 10nm. An example of a nanostructure may be an elongated nanostructure such as a nanowire. The present invention concerns a gate-all-around (GAA) semiconductor nanowire device according to claim 1, including two nanowires as shown, for example in Figure 27. Below, methods will be described, which as such do not fall under the scope of the claimed invention, but are helpful to understand the invention. Gate-all-around (GAA) semiconductor nanowire devices comprising one nanowire will also be described. Similarly, these devices are useful to understand the invention, but do not form part of it. Referring to figure 1, a semiconductor substrate 100 comprising a first crystalline semiconductor material is provided. The substrate 100 may be a bulk silicon (Si) wafer, a bulk germanium (Ge) wafer, a semiconductor-on-insulator (SOI) substrate such as for example Si-O-I or Ge-O-I substrate, or even a strained semiconductor-on-insulator (SSOI) substrate. The semiconductor substrate 100 comprises or consists of a first crystalline semiconductor material. The first crystalline semiconductor material is preferably chosen from a group IV element such as Si or Ge.

Referring to figure 2, shallow trench isolation (STI) regions 101 are formed in the semiconductor substrate 100. The STI regions 101 may be formed by etching trenches and filling the trenches with an insulating material such as for example an oxide (SiO₂). The STI regions 101 define the active regions which will be formed in between subsequent (neighbouring) STI regions 101.

The STI regions 101 may be between 100nm and 500nm deep and may have a width ranging from 500nm down to 20nm. For more advanced STI modules the depth of the STI region can even be below 100nm and the width of the STI region can be down to 5nm. As a rule of thumb, the aspect ratio (it is the ratio between the depth and the width) of the STI regions should be at least 2.

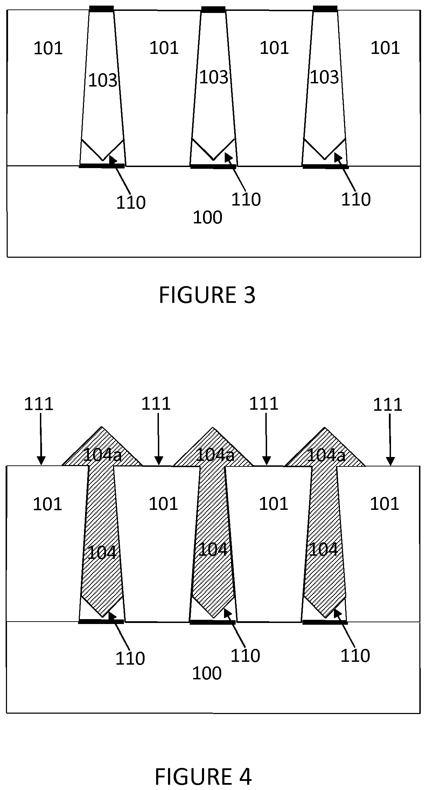

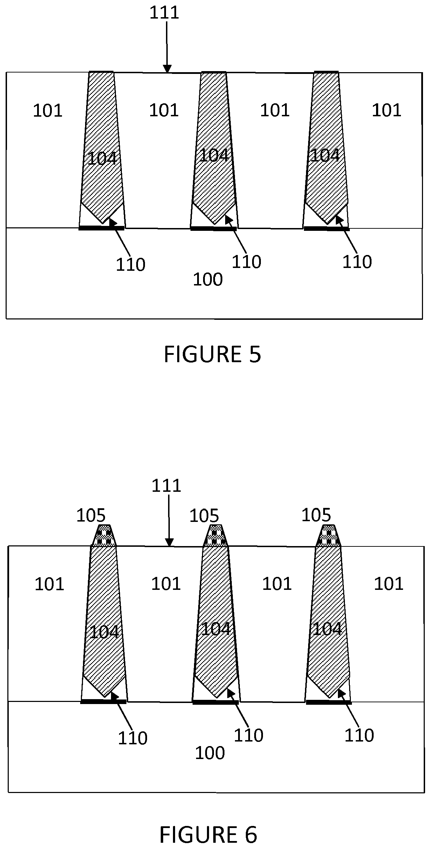

Referring to figures 3 to 5, after forming the STI regions 101, semiconductor fins or lines 104 are formed. Referring to figure 3 part of the first crystalline semiconductor material of the semiconductor substrate 100 is removed in between the STI regions 101. Thereby recesses 103 are created in between the STI regions 101 with a recessed surface 110. The recesses surface 110 may have a different shape depending on the etching chemistry which is used to remove the first crystalline semiconductor material. Preferably an anisotropic etching chemistry is used with a selectivity towards the first crystalline semiconductor material and thus not etching the insulating material of the STI regions 101. The recessing may be done by wet etching or dry etching. Preferably wet etching is used. An example of wet etching is TMAH etch or vapor HCI etch. An example of dry etch is SF₆. Referring to figure 4, a second crystalline semiconductor material 104 is provided on the first crystalline semiconducting material in between the STI regions 101 in the recesses 103. The second crystalline material 104 is lattice mismatched to the first crystalline semiconducting material. The second crystalline material 104 is preferably a high energy bandgap material. The high energy bandgap material is preferably a group III-V material such as for example InP, AlAs, GaAs, GaP, InAs, GaSb, AlSb or the like or a combination thereof such as ternary compounds made thereof (for example InGaAs, InGaP). The second crystalline semiconductor material 104 is epitaxial grown on the first crystalline semiconductor material 100 starting from the recessed surfaces 110 in between the STI regions 101. The second crystalline semiconductor material 104 may also grow above 104a the top surfaces 111 of the STI regions 101. Overgrowth of the second crystalline semiconductor material 104a may be planarized using chemical mechanical polishing (CMP). After CMP, the semiconductor fins comprising the second crystalline semiconductor material 104 and the STI regions 101 are abutting on a common planar top surface 111 (figure 5).

The fins may be rectangular parallelepiped structure having a width, a length and a height, wherein the width and the length are parallel to the substrate and the height is perpendicular to the substrate. The width remains equal along the height of the fin. So the width at the top and the bottom or base of the fin are equal. The bottom of base of the fin is part of the fin closest to the substrate. The top of the fin is at the opposite side of the bottom of the fin.

The fins may be tapered (as shown in the figures). A width at the top of the fin is slightly shorter than the width at the bottom or base of the fin.

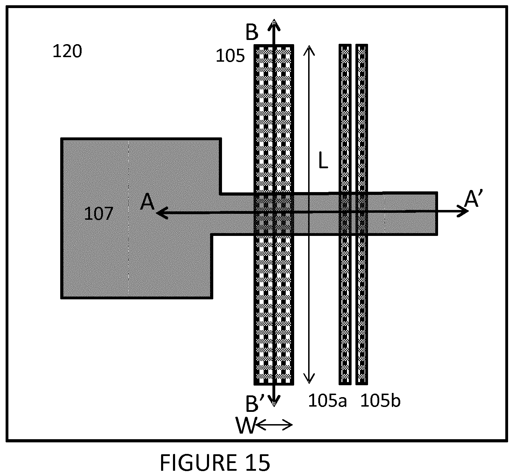

These semiconductor fins or lines 104 have a height equal to the height H of the STI regions 101 and a width W ranged from 100 nm down to 20nm or even down to 5 nm. As a rule of thumb, the aspect ratio (it is the ratio between the depth and the width) of the fins should be at least 2. The semiconductor fins or lines 104 are elongated and lying in a same plane as the common planar top surface (figure 15). The length L of the semiconductor fins or lines may be several nm's, preferably much larger than the width of the fin, for example 10 times larger.

The structure with semiconductor fins or lines in between and isolated by the STI regions is also often referred to as a STI template structure.

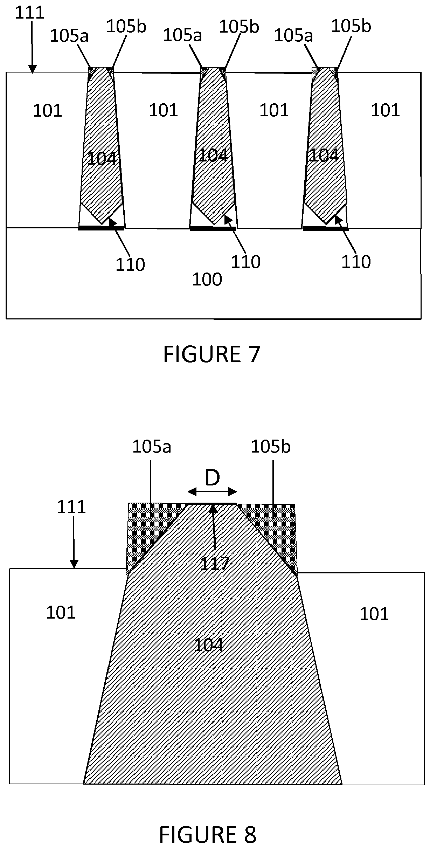

Referring to figure 6 and 7 at least one nanostructure 105, 105a, 105b of a third crystalline semiconductor material is provided on the second crystalline semiconductor material of the semiconductor fins 104. One nanostructure 105 may be provided on the semiconductor fin 104 such as in figure 6. According to the invention, two nanostructures 105a, 105b are provided on the semiconductor fin 104. As shown in figure 8 illustrating in an enlarged partial view of the top part of a fin 104 shown in Figure 7, the two nanostructures 105a, 105b are separated from each other over a distance D. Distance D is larger than 0 nm and is smaller than the width of the semiconductor fin, more preferably smaller than half of the width of the semiconductor fin. The third crystalline semiconductor material of the at least one nanostructure 105, 105a, 105b comprises a high energy bandgap material, preferably a group III-V material InP, AlAs, GaAs, GaP, InAs, GaSb, AlSb or the like or a combination thereof such as ternary compounds made thereof (for example InGaAs, InGaP), which is however different than the second crystalline semiconductor material.
The at least one nanostructure is a lateral nanostructure, i.e. a nanostructure which is lying in the same plane as the substrate top surface or as the STI top surface. This is in contrast with a vertical nanostructure which would extend vertical on the semiconductor substrate surface.

Whereas one nanostructure is provided (figure 6), this may be done by epitaxial growing the third crystalline semiconductor material on the second crystalline semiconductor material of the semiconductor fins 104. The third crystalline semiconductor material is thus grown above the common top surface 111 on the second crystalline semiconductor material in between the STI regions 101. The shape of the nanostructure 105 may vary depending on the growth conditions. The nanostructure may have a <111> faceted shape which resembles a pyramidal shape.

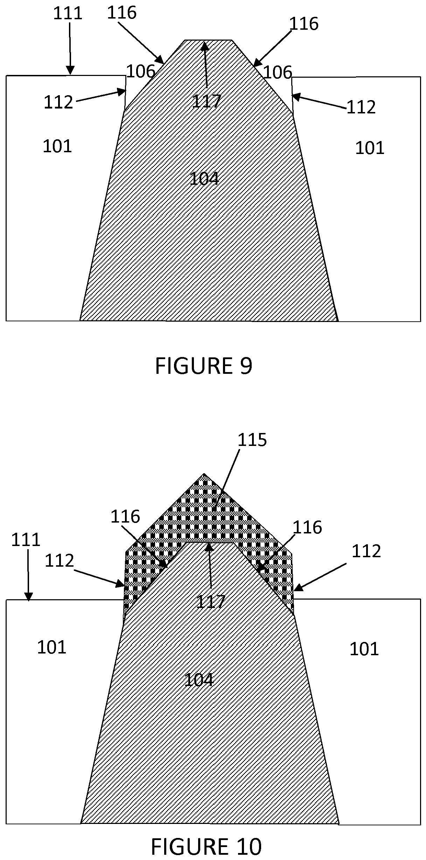

Whereas two nanostructure are provided (figure 7,8), this may be done using the following manufacturing steps (referring to figure 9, 10). After providing the semiconductor fin (comprising the second crystalline semiconductor material), a thermal treatment is performed and the semiconductor fin (comprising the second crystalline semiconductor material) is thus subject to a heat treatment step. The heat treatment step is preferably at a temperature between 500 and 600 degrees Celsius. The heat treatment step may for example be in an environment using TBAs or TBP in a carrier gas comprising hydrogen H₂ for about 1 to 5 minutes. The thermal treatment may be a prebake step and may result in a reflow of the second crystalline semiconductor material or a thermal etching of the second crystalline semiconductor material. Due to the reflow of the second crystalline semiconductor material, a gap 106 is created between the STI sidewall 112 and the now faceted top surface 116 of the second crystalline semiconductor material (figure 9). The middle part of the top surface 117 of the second crystalline semiconductor material of the semiconductor fin will raise preferably above the STI top surface 111. The gaps 106 are thus at a distance D from each other. Distance D is larger than 0 nm and smaller than the width of the semiconductor fin, more preferably smaller than half the width of the semiconductor fin.
After the pretreatment (thermal treatment) step, the gaps 106 are at least partially filled with the third crystalline semiconductor material (figure 10). The gaps 106 may be filed completely. The third crystalline semiconductor material is preferably epitaxial grown on the second crystalline semiconductor material whereby this growth will start from the (reflown) faceted top surface of the second crystalline semiconductor material. The third crystalline semiconductor material will grow in the gaps 106 but possibly also above the top surface 117 of the second crystalline semiconductor material. The overgrown third crystalline semiconductor material may be removed by a CMP step thereby resulting in a structure as schematically shown in figure 8 comprising two nanostructures of third crystalline semiconductor material at a distance D from each other. The CMP step must be done at least down to the top surface 117, but may also be continued until reaching a level below the initial level of the top surface 117.
If the distance D between the two nanostructures is less than the thickness of the gate stack layers, the two nanostructures will merge.
If the top surface 117 of the second crystalline semiconductor material does not extend above the STI top surface 111, different possibilities are possible to make sure the nanostructures will be suspended. One possibility is to perform a CMP step to just below the top surface 117 thereby creating a break between the two nanostructures. Another possibility is to perform a partial STI oxide etch before the thermal treatment step such that the STI top surface 111 is lowered. After the thermal treatment the top surface 117 of the second semiconductor material will be above the lowered STI top surface 111. By using a CMP step to remove part of the third semiconductor material which selectively stops on the STI oxide, the two nanostructures may be suspended.

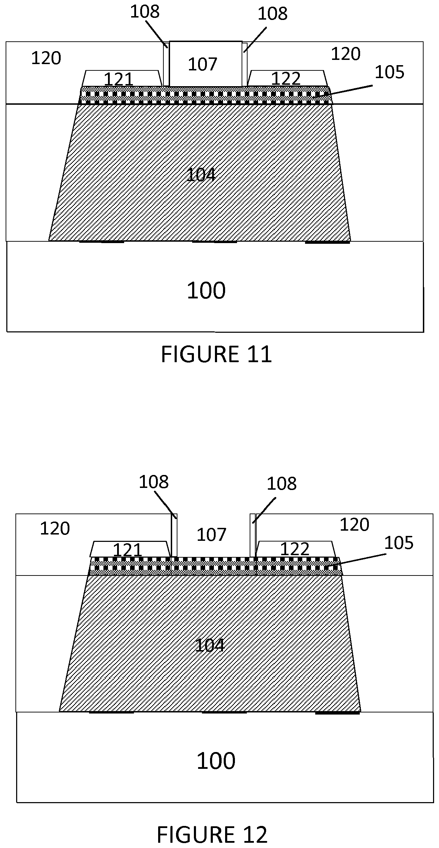

Referring to figure 11, a dummy gate 107 is provided on the at least one nanostructure 105 and a source/drain region is formed on the at least one nanostructure aside of the dummy gate.

Figure 15 shows a top or plan view of the semiconductor device after the dummy gate has been provided. On the left in figure 15 an example is shown with one nanostructure (105), on the right an embodiment according to the invention with two nanostructures (105a, 105b). A dummy gate 107 is provided on top of the at least one nanostructure 105. A dielectric layer 120 is also provided. Figure 1 to 10 refer to side views along the A-A' cross-section, whereas figure 11 to 12 refer to side views along the B-B' cross-section. A dummy gate 107 may be provided using technology as known for a person skilled in the art by providing a gate layer on the at least one nanostructure and patterning this gate layer to form a dummy gate 107. Spacers 108 are processed or provided at the side surfaces of the dummy gate 107. After dummy gate and spacer formation source 121 and drain 122 regions may be provided. This may for example be done by epitaxial growing a fourth semiconductor material on the at least one nanostructure. For isolation of the dummy gate and source/drain regions a dielectric material 120 (interlayer dielectric ILD) is provided on the structure.

After providing the dummy gate 107, the spacers 108 and the source/drain regions 121, 122, the dummy gate 107 is removed (figure 12). Removal of the dummy gate 107 may be done by etching. By removing the dummy gate middle part of the at least one nanostructure is revealed, whereas the outer parts of the at least one nanostructure are connected/contacted to the source and drain regions 121,122.

The nanostructures are thus not suspended by the STI regions, but are suspended by the source/drain regions and possible also by ILD layer 120. The source/drain regions are thereby encased by the ILD layer 120.

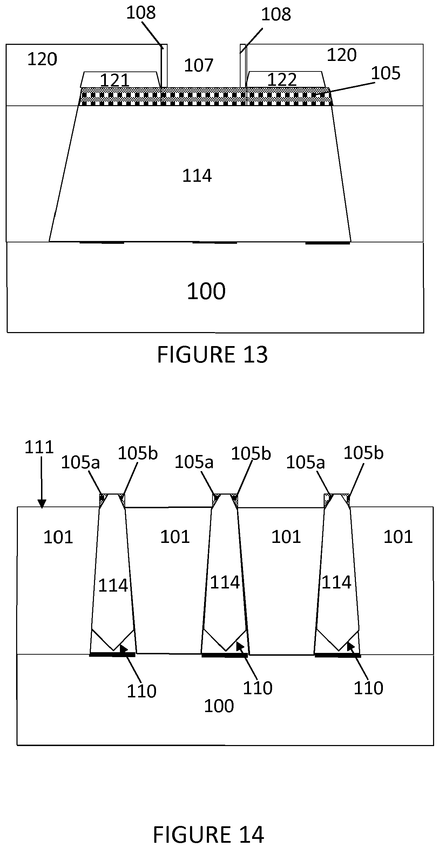

After removal of the dummy gate 107, the second crystalline semiconductor material 104 is removed thereby suspending the at least one nanostructure (figure 13, 14). The at least one nanostructure 105, 105a, 105b is thus suspended above an empty trench 114 and the at least one nanostructure 105, 105a, 105b is held in place by the source and drain regions 121,122. Removal of the second crystalline semiconductor material may be done by etching. Preferably an etch chemistry is used which is selective to the third semiconductor material, for example InP buffer layer may be etched using HCl which is highly selective towards InGaAs channel (nanostructure). Figure 13 shows a cross-section along the B-B' line and figure 14 along the A-A' line after removal of the second crystalline semiconductor material 104. A cavity or empty space 114 is thus created under the at least one nanostructure 105.

By removing the second crystalline semiconductor material 105 underneath the third crystalline semiconductor material the main leakage path is eliminated. Moreover a GAA device maybe fabricated by exposing the nanostructure.

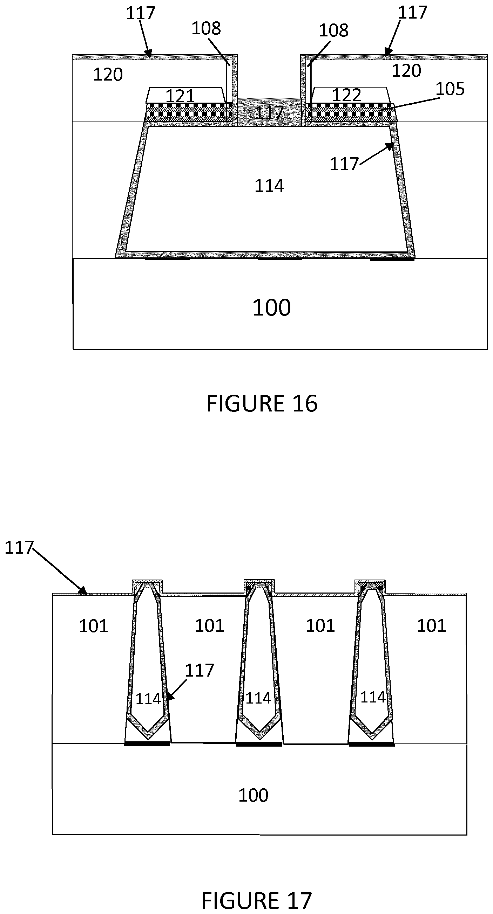

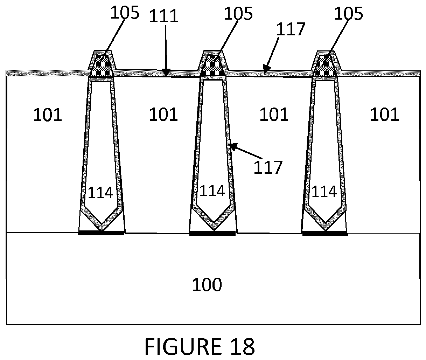

After removing the second crystalline semiconductor material 104 and thereby suspending the at least one nanostructure, a final gate stack may be provided which will cover around the at least one nanostructure, or put differently circumferentially extend around a portion of each nanostructure. Providing the final gate stack comprises providing a gate dielectric layer and a final gate electrode layer on and around the at least nanostructure. Referring to figure 16 for a side view along the B-B' cross-section and to figure 17 (two nanostructures on each fin 104) and figure 18 (one nanostructure on each fin 104) for a side view along the A-A' cross-section, the final gate stack 117 is shown. The final gate stack is preferably provided using a deposition technique such as atomic layer deposition (ALD) such that the layers are provided conformally on the different device components. It is seen from figure 16 and 17 that the final gate stack is formed at the exposed sidewalls of the STI regions 110 in the cavity 114, around the at least one nanostructure 105, 105a, 105b, at the sidewall of the spacers 108 and at the top surface of the dielectric layer 120.

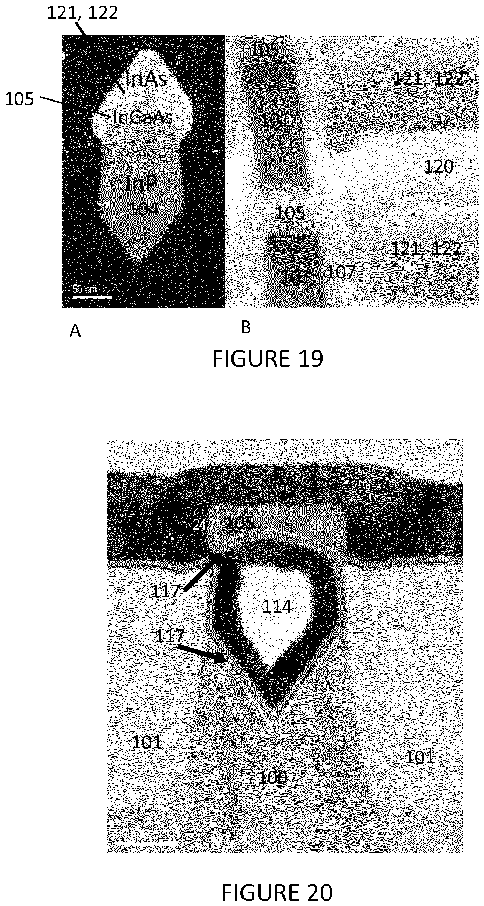

After providing the final gate stack 117, the device may be finalized with the metallization step comprising tungsten gate fill 119 and CMP, contact formation and further back-end-of (BEOL) line processing (see figure 20).

### Experimental Results

InGaAs GAA and lateral nanowire devices have been fabricated. The replacement fin process has been used on 300mm Si substrates. For a gate length (L_{G}) of 60nm an extrinsic transconductance (gₘ) of 1030 µS/µm at a drain/source voltage (V_{ds}) of 0.5 V is achieved which is an increase of almost 2 times compared to the replacement fin FinFet process. This improvement is attributed to the elimination of Mg counterdoping in the GAA flow. Nanowires with diameters of 6 nm were demonstrated to show quantization induced immunity to interface trap density (Dᵢₜ) resulting in a saturated subtreshold slope (SS_{SAT}) of 65 mV/dec for 85 nm L_{G} devices.

### GAA device fabrication and device results

The process flow for fabricating a InGaAs GAA device comprises summarized the following sequence:
- InGaAs fin formation
- Dummy gate patterning
- Spacer processing
- Si doped InAs S/D deposition
- ILD0 deposition and CMP
- Dummy gate removal
- InP buffer removal
- High-k and metal gate deposition
- W gate fill and CMP
- Contact and metal 1

The InGaAs fin is first formed using a replacement fin approach up to the point of the replacement metal gate (RMG) module on 300mm Si substrates. After the dummy gate removal only the part of the fin directly under the gate line is revealed (Fig. 12). A cross-section along (B-B') and across (A-A') the trench is shown in figure 12 and figure 7 respectively before InP removal and in figure 14 and figure 13 respectively after InP removal.

For the replacement fin approach, metal organic vapour phase epitaxy (MOVPE) is used for the III-V growth in order to be compatible with high-throughput processing. However, the carbon that is inherently present in the metal organic precursors (TBP, TBAs, TMIn and TMGa) causes unintentional n-type doping of the InP and InGaAs layers. To counteract this background doping, a p-type Mg doping solution is developed. While the Mg doping was effective in suppressing the off-state source drain leakage current a trade-off is found between the Mg doping level and the channel mobility. Ultimately, the doping induced mobility reduction limits the device performance achievable. From this perspective a GAA architecture is extremely attractive for the InP/InGaAs system. By removing the n-type InP buffer layer from underneath the InGaAs channel the main leakage path is eliminated without the penalty of reduced mobility

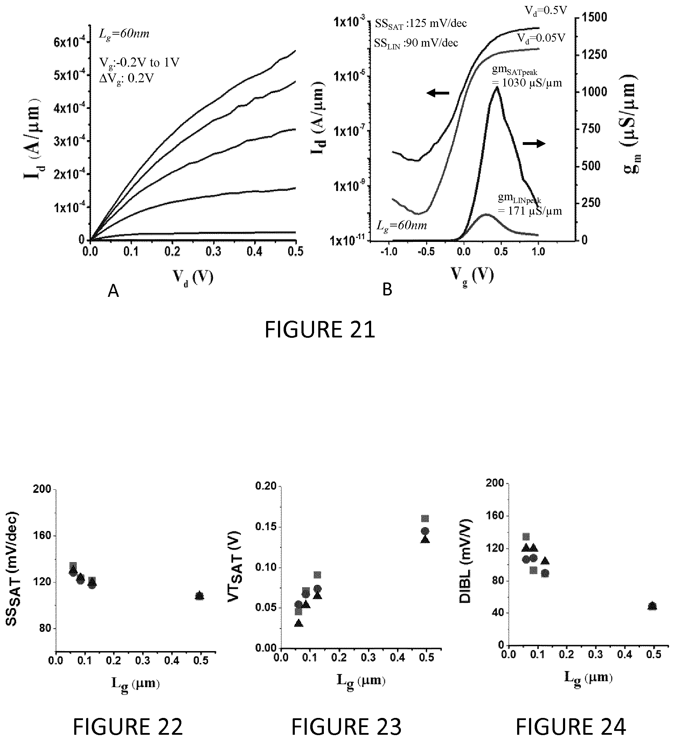

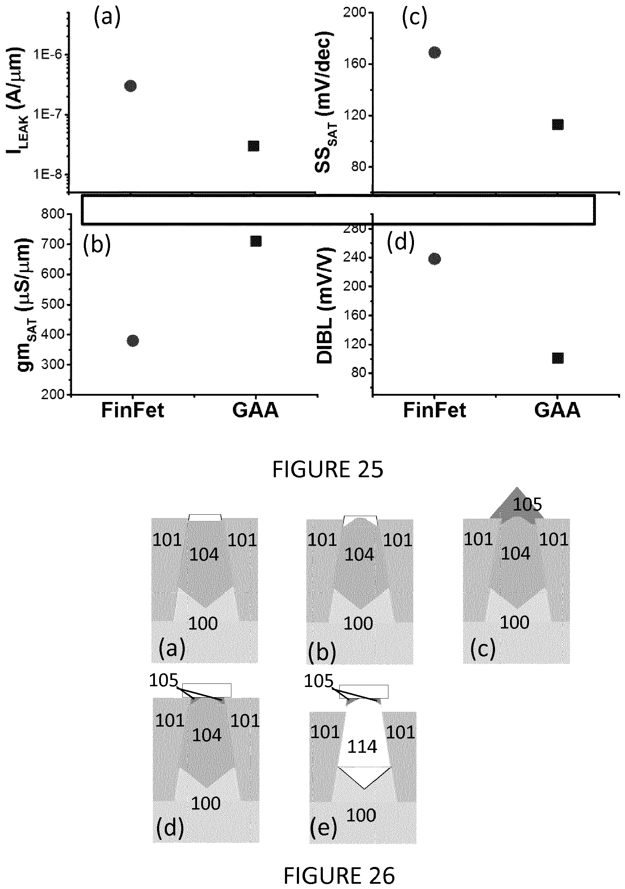

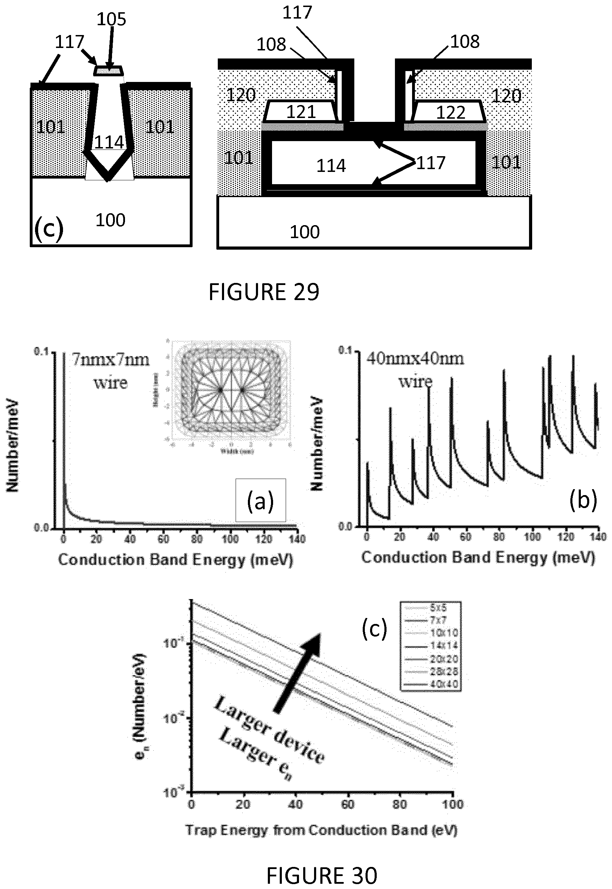

The STI fin recess is sufficiently deep to expose the InP buffer layer and HCl:H₂O is used to selectively etch the InP with respect to the InGaAs channel. This results in an InGaAs channel layer being suspended above the now empty trench and held in place by the N+ InAs source/drain (SD) layer (Fig. 19, 20) which is encased by the inter layer dielectric (ILD) stack. The high-k gate stack of 2nm Al₂O₃/2nm HfO₂/3nm TiN is deposited by ALD. The high-k gate stack has an equivalent oxide thickness (EOT) of 1.5nm. Processing is then completed by W gate fill and CMP followed by standard W-plug contact and metal 1 (M1) modules. A TEM of a completed 95nm wide GAA InGaAs device is shown in figure 20, which is comparable to the schematic presentation in figure 18. Here it is clearly seen that the InP buffer has been fully removed and the channel comprises a block of InGaAs that is wrapped all around by the gate stack. I-V characteristics of a 60nm L_{G} device with a channel width of 95nm and a maximum thickness of 30nm at different gate voltages (0.2V lower line in steps of 0.2V to 1 V upper line) are shown in figure 21A. The InGaAs shape is rounded due to the reflow of the InP during the pre-bake step of the InGaAs deposition. A peak extrinsic gₘ of 1030 uS/um is achieved with a SS of 125 mV/dec at V_{ds}=0.5V (figure 21B). SCE as a function of channel width and gate length are shown in figures 22 to 24. Figure 22 shows the saturated subtreshold slope (SSat) as a function of gate length Lg and width W. Figure 23 shows the saturated threshold voltage (VTsat) as a function of gate length Lg and width W. VT is defined at a drain current Id equal to 1µA/µm. Figure 24 shows drain-induced barrier lowering DIBL as a function of gate length Lg and width W. Width W in figures 22, 23 and 24 is varied from 55nm (rectangles) to 75nm (circles) to 95nm (triangles). Threshold voltage (V_{T}) roll-off and degradation of SS and DIBL is observed as the L_{G} is scaled from long to short channel. The channel widths are too large with respect to the channel thickness (15-27nm) to have a large impact. It is expected that more aggressive scaling of the width and EOT will yield further improvements. The performance of the GAA devices (rectangles) is compared to that of the FinFet (circles) devices in figure 25A-D at a gate length of 125nm and a same fin width of 55nm. The increased electrostatic control of the GAA architecture results in a lower off state leakage despite the fact no counter-doping of the channel was employed. As expected both SS_{SAT} and DIBL are also significantly improved. The near 2x improvement in gₘ obtained with the GAA flow is indicative of the improved transport properties of the channel due to the absence of Mg counterdoping. A modification of the fin process is shown in figure 26. A dual nanowire channel and process steps for manufacturing such dual nanowire channel is shown. After a shallow InP-filled recess 104 is formed (a), a pre-bake before the InGaAs deposition results in a reflow (and rounding) of the InP buffer layer 104 (b). The gap created between the STI 101 sidewall and the now faceted InP 104 is subsequently filled with InGaAs 105 (c). After a CMP process of the InGaAs 105 (d), the STI 101 is recessed and the InP 104 is etched (e) to reveal the suspended nanowires 105a, 105b. If the InP recess is shallow enough after the channel CMP step only these two small regions of InGaAs (e) will remain which then become suspended nanowires after the InP removal (figure 26). This process is used to generate wires with diameters of only 6 nm. After suspending the nanowires a gate stack is provided as shown in figure 29 (which is an example of one nanostructure and comparable to the schematics in figure 16 and 18). A high-k/TiN gate stack is provided around the InGaAs nanostructure and in the gap on the STI sidewalls. A SEM image of a dual nanowire fabricated according to a method of the present disclosure is shown in figure 27. A 4nm and 6,5nm wide InGaAs nanowire is fabricated surrounded by a TiN/HfO₂/Al₂O₃ gate stack. Remarkably, the SS_{SAT} of short channel devices could be reduced to values as low as 65 mV/dec with negligible DIBL compared to the typical values of 120 mV/dec and 100-120 mV/V for the thicker GAA devices (figure 28). This improvement is attributed to a quantization induced immunity to Dit. However, the quantization also increases sensitivity to border traps in the high-k layer highlighting the need for a wide bandgap interlayer between the channel and high-k stack. Surface state traps should have a negligible impact on the SS of ultra-scaled GAA structures and this has been linked to the superior gate control of the small nanowire compared to the larger bulk like devices. To explore the effect of the band structure on the SS we use an 8 band k.p solver to study the impact of quantization effects on the thermionic emission rate (eₙ) of the interface traps. The simulations show that the low DOS of highly confined structures compared to those of wires with relaxed dimensions effectively limits the emission rates of the traps (Figure 30). This lower eₙ combined with the superior gate control results in the suppression of Dᵢₜ induced degradation in the nanowire device. The I_{SAT} of the nanowire devices is also decreased which would be expected from the lower DOS, increased phonon scattering and effective mass associated with increased confinement. Quantization also results in an increase in the sub-band energy levels potentially allowing for a greater interaction of the channel charge with traps deeper in the high-κ layer. Further investigation is needed to determine if optimization of the trap profile in the gate stack can boost the on performance

## Claims

1. A gate-all-around (GAA) semiconductor device comprising a semiconductor substrate (100) comprising a first crystalline semiconductor material; two suspended nanowires (105a, 105b) horizontally adjacent at a distance D being located at least partially above and in between a pair of adjacent STI regions (101) and the two suspended nanowires being held in place by a source region (121) and a drain region (122) at both ends of the two suspended nanowires, the two suspended nanowires comprising a crystalline Group III-V semiconductor material which is different from the first crystalline semiconductor material, wherein a cavity (114) is present between the suspended nanowires, opposite sidewalls of the STI regions and the semiconductor substrate, wherein the suspended nanowires are wrapped by a final gate stack (117) and wherein the top surface and the sidewalls of the STI regions and the exposed surface of the semiconductor substrate inside the cavity are also covered by the final gate stack and
wherein distance D is larger than the thickness of the final gate stack and is smaller than the width of the cavity.

2. A gate-all-around (GAA) semiconductor device according to claim 1 wherein the first crystalline semiconductor material is Si.

3. A gate-all-around (GAA) semiconductor device according to claim 2 wherein the group III-V material comprises any of InP, AlAs, GaAs, GaP, InAs, GaSb, AlSb, InGaP, InGaAs.

4. A gate-all-around (GAA) semiconductor device according to any of the preceding claims wherein the suspended nanowires have a width between 2nm and 10nm.

## Patentansprüche

1. Gate-all-Around-, GAA, Halbleitervorrichtung, umfassend ein Halbleitersubstrat (100), umfassend
ein erstes kristallines Halbleitermaterial; zwei herabhängende Nanodrähte (105a, 105b), die in einem Abstand D horizontal benachbart sind und mindestens teilweise über und zwischen einem Paar benachbarter STI-Gebiete (101) liegen, und
wobei die zwei herabhängenden Nanodrähte durch ein Source-Gebiet (121) und ein Drain-Gebiet (122) an beiden Enden der zwei herabhängenden Nanodrähte in Position gehalten werden, wobei die zwei herabhängenden Nanodrähte ein kristallines Halbleitermaterial der Gruppe III-V umfassen, das ein anderes als das erste kristalline Halbleitermaterial ist, wobei ein Hohlraum (114) zwischen den herabhängenden Nanodrähten, gegenüberliegenden Seitenwänden der STI-Gebiete und dem Halbleitersubstrat vorhanden ist, wobei die herabhängenden Nanodrähte von einem abschließenden Gate-Stapel (117) umhüllt sind und wobei die obere Oberfläche und die Seitenwände der STI-Gebiete und die freiliegende Oberfläche des Halbleitersubstrats innerhalb des Hohlraums ebenfalls von dem abschließenden Gate-Stapel abgedeckt sind und
wobei der Abstand D größer als die Dicke des abschließenden Gate-Stapels ist und kleiner als die Breite des Hohlraums ist.

2. Gate-all-Around-, GAA, Halbleitervorrichtung nach Anspruch 1, wobei das erste kristalline Halbleitermaterial Si ist.

3. Gate-all-Around-, GAA, Halbleitervorrichtung nach Anspruch 2, wobei das Material der Gruppe III-V ein beliebiges von InP, AlAs, GaAs, GaP, InAs, GaSb, AlSb, InGaP, InGaAs umfasst.

4. Gate-all-Around-, GAA, Halbleitervorrichtung nach einem der vorstehenden Ansprüche, wobei die herabhängenden Nanodrähte eine Breite zwischen 2 nm und 10 nm aufweisen.

## Revendications

1. Dispositif à semi-conducteur à grille tout autour (GAA) comprenant un substrat de semi-conducteur (100) comprenant un premier matériau semi-conducteur cristallin; deux nanofils suspendus (105a, 105b) horizontalement adjacents à une distance D situés au moins en partie au-dessus et entre une paire de régions STI adjacentes (101) et les deux nanofils suspendus étant maintenus en place par une région de source (121) et une région de drain (122) aux deux extrémités des deux nanofils suspendus, les deux nanofils suspendus comprenant un matériau semi-conducteur cristallin des groupes III-V qui est différent du premier matériau semi-conducteur cristallin, dans lequel une cavité (114) est présente entre les nanofils suspendus, en regard des parois latérales des régions STI et du substrat de semi-conducteur, dans lequel les nanofils suspendus sont entourés par une pile de grille finale (117) et dans lequel la surface supérieure et les parois latérales des régions STI et la surface exposée du substrat de semi-conducteur à l'intérieur de la cavité sont également couvertes par la pile de grille finale et dans lequel la distance D est plus grande que l'épaisseur de la pile de grille finale et est plus petite que la largeur de la cavité.

2. Dispositif à semi-conducteur à grille tout autour (GAA) selon la revendication 1, dans lequel le premier matériau semi-conducteur cristallin est Si.

3. Dispositif à semi-conducteur à grille tout autour (GAA) selon la revendication 2, dans lequel le matériau des groupes III-V comprend l'un quelconque de InP, AlAs, GaAs, GaP, InAs, GaSb, AlSb, InGaP, InGaAs.

4. Dispositif à semi-conducteur à grille tout autour (GAA) selon l'une quelconque des revendications précédentes, dans lequel les nanofils suspendus ont une largeur entre 2 nm et 10 nm.
